# EUROPÄISCHE PATENTSCHRIFT

(11) **EP 1 182 276 B1**
(45) Veröffentlichungstag und Bekanntmachung des Hinweises auf die Patenterteilung: **02.01.2008**
(21) Anmeldenummer: 01119519.5
(22) Anmeldetag: 14.08.2001
(51) Int. Cl.: C23C 16/44, C23C 16/40, C30B 29/32, H01L 21/316, C23C 16/455

(54) **Verfahren zur Herstellung einer ferroelektrischen Festkörperschicht unter Verwendung eines Hilfsstoffes**
Process for the production of a ferroelectric solid layer using an additive
Procédé de production d'une couche solide ferroélectrique utilisant un additif

(30) Priorität: 24.08.2000 DE 10041698
(43) Veröffentlichungstag der Anmeldung: 27.02.2002
(73) Patentinhaber: Qimonda AG, 81739 München (DE)
(72) Erfinder: Kersch, Alfred, 85640 Putzbrunn (DE); Spitzer, Andreas, 85521 Ottobrunn (DE)
(74) Vertreter: Graf Lambsdorff, Matthias

(56) Entgegenhaltungen:
- US-A- 5 104 690
- US-A- 5 753 300
- SAULYS D ET AL: "An examination of the surface decomposition chemistry of lithium niobate precursors under high vacuum conditions" JOURNAL OF CRYSTAL GROWTH, NORTH-HOLLAND PUBLISHING CO. AMSTERDAM, NL, Bd. 217, Nr. 3, 1. August 2000 (2000-08-01), Seiten 287-301, XP004213541 ISSN: 0022-0248
- WILLS L A ET AL: "DEPOSITION OF FERROELECTRIC BI4TI3O12 THIN FILMS" EXTENDED ABSTRACTS, ELECTROCHEMICAL SOCIETY. PRINCETON, NEW JERSEY, US, Bd. 90 / 2, 1990, Seite 781 XP000294124 ISSN: 0160-4619
- GAO Y ET AL: "EFFECTS OF PRECURSORS AND SUBSTRATE MATERIALS ON MICROSTRUCTURE, DIELECTRIC PROPERTIES, AND STEP COVERAGE OF (BA,SR)TIO3 FILMS GROWN BY METALORGANIC CHEMICAL VAPOR DEPOSITION" JOURNAL OF APPLIED PHYSICS, AMERICAN INSTITUTE OF PHYSICS. NEW YORK, US, Bd. 87, Nr. 1, 1. Januar 2000 (2000-01-01), Seiten 124-132, XP000947611 ISSN: 0021-8979
- PATENT ABSTRACTS OF JAPAN vol. 009, no. 145 (C-287), 20. Juni 1985 (1985-06-20) & JP 60 026663 A (TOSHIBA CERAMICS KK;OTHERS: 01), 9. Februar 1985 (1985-02-09)

## Beschreibung

Die Erfindung betrifft ein Verfahren zur Herstellung einer ferroelektrischen Strontium-Wismut-Tantalat-Festkörperschicht durch Gasphasenabscheidung (Chemical Vapor Deposition, CVD) auf einem Substrat gemäss Patentanspruch 1.

In der Halbleiter-, insbesondere der Silizium-Technologie ist es mittlerweile bekannt, für verschiedene Zwecke ferro- oder paraelektrische Materialien einzusetzen. Derartige Schichten können ersatzweise für das normalerweise aus einer Oxid- oder Nitridschicht bestehende Dielektrikum eines Speicherkondensators eines DRAM-Halbleiterspeichers verwendet werden. Der Vorteil dieser sogenannten FeRAMs liegt zum einen in der sehr viel höheren Dielektrizitätskonstante des ferroelektrischen Materials und zum anderen in der Möglichkeit, mittels der remanenten Polarisation des ferroelektrischen Materials einen nicht-flüchtigen Speicherbaustein herzustellen.

Ferner kann bei MOS-Transistoren eine ferroelektrische Schicht ersatzweise für die Gate-Oxidschicht als Isolationsschicht zwischen der Gate-Elektrode und dem Kanalabschnitt der Halbleiteroberfläche gebildet werden, wodurch ein nichtflüchtiger Speichertransistor hergestellt werden kann.

Als ferroelektrische Materialien sind beispielsweise die als Strontium-Wismut-Tantalat bekannten Zusammensetzungen SrBi₂Ta₂O₉ (SBT) und SrBi₂(Ta, Nb)₂O₉ (SBTN), sowie ferner Pb(Zr, Ti)O₃ (PZT, Blei-Zirkonat-Titanat) oder Bi₄Ti₃O₁₂ (BTO) für eine praktische Anwendung in einem ferroelektrischen Speicherkondensator oder einem Speichertransistor denkbar. Als ein paraelektrisches Material ist beispielsweise Barium-Strontium-Titanat in der Zusammensetzung (Ba, Sr)TiO₃ (BST) bekannt.

Für die gedachten Anwendungen als ferroelektrisches Speicherbauelement in höchster Packungsdichte ist es notwendig, die ferro- oder paraelektrischen Materialien mit einer hinreichend hohen Abscheiderate und sehr guter Uniformität der Schichtdicke und Stöchiometrie über einen großen Wafer abzuscheiden. Diese Anforderungen lassen sich im Prinzip mit der Abscheidung aus der Gasphase, d.h. einem CVD-Prozeß, insbesondere - bei Beteiligung von Metallen - einem metallorganischen CVD-(MOCVD-)Prozeß erfüllen. In der jüngsten Vergangenheit wurden Precursoren für die genannten Materialien identifiziert und evaluiert. Im Falle der paraelektrischen BST sind dies z.B. Ti(ipro)₂ (thd)₂ (ipro = iso-propoxy, thd = 2,2, 6,6-tetramethyl-heptan-3,5-diketon), Ba (thd)₂ und Sr (thd)₂, die in einer oxidierenden Atmosphäre und thermisch aktiviert zur Abscheidung gebracht werden. Im Falle des ferroelektrischen SBT sind dies z.B. Sr (thd)₂, Bi (thd)₃ und Ta (ipro)₄ (thd), die in einer oxidierenden Atmosphäre und thermisch aktiviert zur Abscheidung gebracht werden. Um die gewünschten para- oder ferroelektrischen Materialeigenschaften zu erhalten, ist es notwendig, den Film in der richtigen Stöchiometrie und einer geeigneten Anordnung auf atomarer Ebene abzuscheiden, damit sich z.B. beim SBT die Aurivillius-Phase mit geeigneter Stöchiometrie, Korngröße und einer bevorzugten [100] - und [110] -Orientierung ausbildet.

Für den CVD-Prozeß werden die metallorganischen Verbindungen in einem Verdampfer gasförmig gemacht und zusammen mit dem Trägergas Argon und Sauerstoff über eine Verteilerplatte (Lochplatte) in die Reaktorkammer geleitet. Die Precursoren gelangen zu dem Wafer, welcher auf eine höhere Temperatur aufgeheizt ist, um die für die Abscheidung notwendige Aktivierungsenergie zu liefern. Die Reaktionsprodukte und die nicht zerlegten Radikale werden dann mit der Gasströmung in den Außenbereich des Reaktors transportiert, von wo sie abgepumpt werden. Zu diesem Zeitpunkt finden weitere Reaktionen in der Gasphase als auch an den Innenwänden des Reaktors statt.

Bei der Prozeßevaluierung wurden sowohl bei der Abscheidung von BST als auch bei der Abscheidung von SBT Probleme beobachtet. Beim BST war die Uniformität auf dem Wafer nicht ausreichend. Es wurde sowohl eine von der Mitte bis zum Rand abfallende Schichtdicke festgestellt als auch eine sich verändernde Stöchiometrie. Zusätzlich änderte sich die relative Häufigkeit der Kristallorientierungen. Beim SBT gelang es zunächst, in einem Reaktor ferroelektrische Schichten herzustellen. Wurde jedoch der Prozeß in einem Reaktor mit anderer Geometrie durchgeführt (der wesentliche Unterschied war hier der viel geringere Abstand zwischen der Verteilerplatte und dem Substratwafer), war die Polarisierbarkeit der Schicht viel geringer.

Es ist daher Aufgabe der vorliegenden Erfindung, ein Verfahren zur Herstellung einer ferroelektrischen Strontium-Wismut-Tantalat-Festkorperschicht durch Gasphasenabscheidung anzugeben, mit welchem sich Schichten ausreichender Uniformität hinsichtlich der Schichtdicke, der Stöchiometrie und der elektrischen Eigenschaften herstellen lassen.

Diese Aufgabe wird mit den Merkmalen des Patentanspruchs 1 gelöst.

Ein wesentlicher Gedanke der vorliegenden Erfindung besteht darin, bei einem Verfahren zur Herstellung einer eine Perowakit-Struktur aufweisenden kristallinen, ferroelektrischen Strontium-Wismut-Tantalat-Festkorperschicht durch Gasphasenabscheidung (CVD) auf einem Substrat zusätzlich zu den die Elemente der abzuscheidenden Festkörperschicht enthaltenden Ausgangsgasen einen Hilfsstoff aus Wasser oder Methanol in den Reaktionsraum einzuleiten. Ein Hilfsstoff dieser Art ist derart beschaffen, daß er Moleküle enthält, die ein Dipolmoment aufweisen und darüber hinaus die Eigenschaft haben, sich während des Abscheideprozesses kurzzeitig an der Substratoberfläche mit zu der Substratoberfläche senkrechtem Dipolmoment anzulagern, um somit die Kristallstruktur der aufzuwachsenden Schicht vorzugeben. Zusätzlich ist der Abstand zwischen einer in der Reaktokrammer ungeordneten verteilerplatte und dem Substrat auf weniger als 2 cm eingestellt.

Der Erfindung liegt die aus Simulationsrechnungen und Experimenten gewonnene Erkenntnis zugrunde, daß bei dem Abscheidungsprozeß, wie er in der Vergangenheit durchgeführt wurde, derartige polare Moleküle eine wichtige Rolle für ein Aufwachsen der Schicht mit der richtigen Vorausrichtung der später ferroelektrischen Schicht spielen. Es wurde herausgefunden, daß polare Moleküle wie Wasser oder Methanol als Zersetzungsprodukte der Precursoren bei den verschiedenen Reaktionen entstehen und sich als Adsorbat mit ihrem Dipolmoment senkrecht zur Oberfläche ausrichten und damit die Vorausrichtung der später ferroelektrischen Schicht und damit ihre Polarisierbarkeit beeinflussen.

Die durch die Oberflächenreaktion der Precursoren an freien Oberflächenplätzen freiwerdenden Moleküle, insbesondere Radikale, werden zunächst weiteren Reaktionen unterworfen, und zwar alternativ sowohl in der Gasphase als auch an den außen gelegenen Reaktorwänden. Die bei dieser sekundären Reaktion entstehenden Moleküle mit Dipolmoment, insbesondere Radikale, diffundieren dann aufgrund von Konzentrationsunterschieden gegen die Gasströmung zurück zum Wafer und besetzen reaktive Oberflächenplätze. Da diese polaren Moleküle das Schichtwachstum in der oben beschriebenen Weise beeinflussen, über dem Wafer jedoch nicht mit konstanter Dichte vorhanden sind, kommt es zu Inhomogenitäten beim Wachstumsprozeß. Es wurde daher zunächst versucht, in der Prozeßevaluierung beim Abscheiden von SBT-Schichten den Einfluß dieser polaren Moleküle zurückzudrängen. Dies wurde dadurch erreicht, indem der Abstand zwischen der Verteilerplatte und dem Wafer verringert wurde. In diesem Fall werden die Reaktionsprodukte im wesentlichen vollständig abgepumpt und es kommt zu keiner nennenswerten Rückdiffusion und Anlagerung an der Oberfläche. Es wurde jedoch festgestellt, daß die Schicht dann zwar räumlich homogen und mit konstanter Schichtdicke aufwächst, aber keine ferroelektrischen Eigenschaften aufweist. Die polaren Moleküle sind also offensichtlich für die Herstellung einer Schicht mit ferroelektrischen Eigenschaften notwendig.

Die vorliegende Erfindung zieht daraus die Konsequenz, in dem Reaktionsraum dem verwendeten Gasgemisch aus metallorganischen Precursoren und Trägergas gezielt Wasser-oder Methanol- Moleküle mit Dipolmoment in geringer Konzentration beizumischen, durch die die gewünschte Ausrichtung der aufzuwachsenden Schicht begünstigt werden kann. Insbesondere beim Abscheiden der eingangs genannten Materialien, die in der Perowskit-Struktur kristallisieren, kann erfindungsgemäß die gewünschte Ausrichtung in der Perowskit-Struktur erreicht werden. Damit gelangen die polaren Moleküle kontrolliert von allen Seiten zu der Substratoberfläche und nicht - wie bisher - nur durch Diffusion von den Außenbereichen des Reaktors. Über die Menge des zugeführten Hilfsstoffes besteht eine weitere Regelmöglichkeit für den Prozeß, der über die bisherigen Größen wie Zusammensetzung in der Gasphase, Temperatur und Druck hinausgeht.

Die zwischenzeitlich absorbierten polaren Wasser- oder Methanol-Moleküle fungieren gleichsam wie ein virtuelles Gerüst, das ständig seine Gestalt ändert, da die polaren Moleküle jeweils nur kurzzeitig absorbiert sind, um in ihrer unmittelbarer Umgebung für die korrekte Ausrichtung der aufzuwachsenden Schicht sorgen und anschließend wieder in die Gasphase diffundieren.

In einer ersten Ausführungsart der Erfindung wird die Art des Hilfsstoffes vorab festgelegt und der Hilfsstoff aus einer externen Versorgungsquelle wie einem Vorratsbehälter oder dergleichen dem Reaktionsraum vorzugsweise über eine eigene Zuführungsöffnung zugeführt. Der Hilfsstoff kann Wasser oder Methanol sein; in beiden Fällen besitzen die entsprechenden Wasser- oder Methanol-Moleküle ein Dipolmoment.

Bei den meisten Reaktionen unter Beteiligung von metallorganischen Precursoren fällt Wasser auch als Zersetzungsprodukt der weiter oben genannten sekundären Reaktionen an. Daher können auch gemäß einer zweiten Ausführungsart der Erfindung die aus der Reaktionskammer abgepumpten Reaktionsprodukte des Abscheidungsprozesses der Reaktionskammer erneut an andere Stelle zugeführt werden. In diesem Fall wird also der Hilfsstoff durch die aus der Reaktionskammer abgepumpten Reaktionsprodukte Wasser oder Methanol gebildet. Diese zweite Ausführungsart kann generell in allen Fällen zum Einsatz kommen, in denen es bekannt ist, daß Wasser oder Methanol als Reaktionsprodukte existieren.

Das erfindungsgemäße Verfahren wird in einer Reaktorkammer durchgeführt, in welcher eine Verteilerplatte, insbesondere eine Lochplatte, angeordnet ist, auf deren einer Seite die Ausgangsgase für den Abscheideprozeß, der Hilfsstoff und ggf. ein Trägergas durch Einlaßöffnungen in der Reaktorwand eingeleitet werden, und auf deren anderer Seite das Substrat gehaltert ist. In einer den Einlaßöffnungen der Reaktorkammer gegenüberliegenden Reaktorwand befindet sich eine Auslaßöffnung, die an einer Pumpe angeschlossen ist, mit der die Reaktionsprodukte aus der Reaktorkammer abgepumpt werden.

Für die erste Ausführungsart der Erfindung wird die Einlaßöffnung für den Hilfsstoff mit einem externen Vorratsbehälter verbunden, während für die zweite Ausführungsart der Erfindung diese Einlaßöffnung mit einer stromabwärts des Substrats in einer Reaktorwand befindlichen Ausgangsöffnungen verbunden wird, durch welche die Reaktionsprodukte geleitet werden und somit erneut in die Reaktorkammer auf der einen Seite der Verteilerplatte zurückgeführt werden.

Die Bedingungen der Gasphasenabscheidung hängen bei dem verwendeten Reaktorkonzept wesentlich von dem Abstand der Verteilerplatte zu dem Substrat ab. Bei relativ großem Abstand tritt eine Situation ein, wie sie eingangs beschrieben worden ist, bei der sich nämlich durch Rückdiffusion oder dergleichen eine bestimmte Dichte von Reaktionsprodukten über dem Substratwafer einstellt. In diesem Fall kommt es zu einer Überlagerung der Dichte des zugeführten Hilfsstoffs und dieser Reaktionsprodukte, die zu Inhomogenitäten beim Wachstum führen kann. Bei der Erfindung wird die Gasphasenabscheidung daher derart durchgeführt, daß es nicht zu einer nennenswerten Rückdiffusion der Reaktionsprodukte kommt, so daß Moleküle, durch die das Wachstum der Schicht positiv beeinflußt wird, im wesentlichen oder zur Gänze durch den zugeführten Hilfsstoff Wasser oder Methanol gelierert werden. Dadurch wird sichergestellt, daß die Dichte derartiger Moleküle über dem Substrat räumlich konstant ist. Dies wird dadurch erreicht, indem ein relativ geringer Abstand zwischen Verteilerplatte und Substratwafer eingestellt wird. Der Abstand beträgt weniger als 2 cm, vorzugsweise etwa 1 cm.

Im folgenden wird das erfindungsgemäße Verfahren anhand der Zeichnungsfiguren näher erläutert. Es zeigen:
- Fig. 1: eine Querschnittsansicht einer Reaktorkammer gemäß einer ersten Ausführungsart der Erfindung;
- Fig. 2: eine Querschnittsansicht einer Reaktorkammer gemäß einer zweiten Ausführungsart der Erfindung.

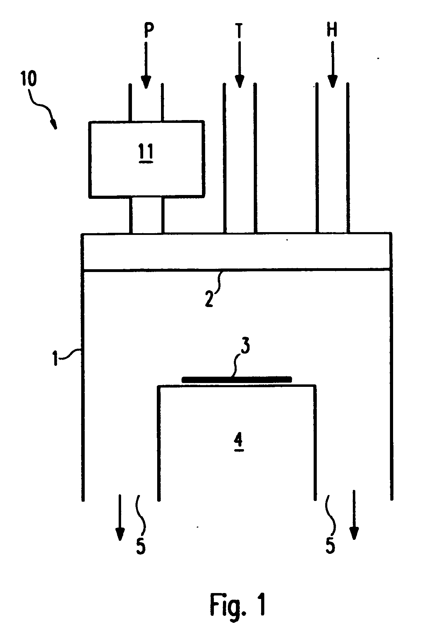

Eine in der Fig. 1 dargestellte Reaktorkammer 10 ist beispielsweise zylinderförmig ausgeführt und weist eine Reaktorwand 1 auf, die an der oberen Stirnseite der zylinderförmigen Reaktorkammer drei Einlaßöffnungen aufweist, durch die Ausgangsgase wie geeignete Precursoren P, ein Trägergas T sowie ein Hilfsstoff H (Wasser oder Methanol) der Reaktorkammer 1 zugeführt werden. Der Precursor P wird in der Regel in flüssiger Form zugeführt und in einem Verdampfer 11 in den gasförmigen Zustand überführt. In einem Abstand unterhalb der Einlaßöffnungen befindet sich eine Verteilerplatte 2, in der Regel eine Lochplatte, durch die ein annähernd lateral homogener Gasfluß erzeugt wird. In einem Abstand von der Verteilerplatte 2 ist ein Substratwafer 3 auf einem beheizbaren Suszeptor 4 in geeigneter Weise montiert. In der den Einlaßöffnungen gegenüberliegenden unteren Stirnseite des Reaktorgefäßes befindet sich ein Gasauslaß 5, an den eine Pumpe angeschlossen wird, durch die die Reaktionsprodukte abgepumpt werden.

Für den Fall der Abscheidung von BST werden beispielsweise die Precursoren P Ti(ipro)₂ (thd)₂ (ipro=iso-propoxy, thd=2,2, 6,6-tetramethyl-heptan-3,5-diketon), Ba (thd)₂ und Sr (thd)₂ verwendet. Im Falle der Abscheidung von SBT werden beispielsweise die Precursoren P Sr (thd)₂, Bi (thd)₃ und Ta (ipro)₄ (thd) verwendet. Als Trägergas T kann beispielsweise Argon und Sauerstoff verwendet werden. Als Hilfsstoff H wird Wasser oder Methanol aus einem externen Vorratsbehälter zugeführt.

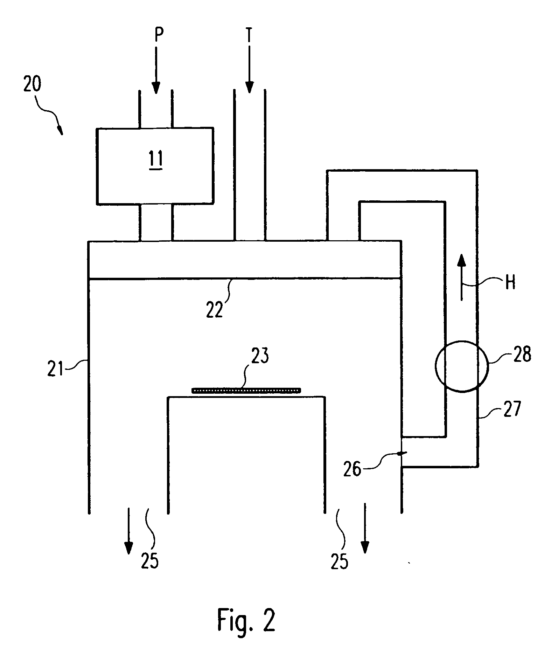

In der Ausführungsform gemäß der Fig. 2 befindet sich in der Reaktorkammer 21 zusätzlich zu dem Gasauslaß 25 eine weitere seitliche Öffnung 26 in der Reaktorwand 21 stromabwärts von dem Substrat 23. Diese zusätzliche Auslaßöffnung 26 ist durch eine Rohrleitung 27 mit der für den Einlaß des Hilfsstoffs H in die Reaktorkammer 20 vorgesehenen Einlaßöffnung verbunden. Der Hilfsstoff H wird in diesem Fall durch einen Teil der abgepumpten Reaktionsprodukte aus Wasser oder Methanol. Durch ein Ventil 28 kann der Gasfluß der in der Rohrleitung 27 zurückgeführten Reaktionsprodukte gesteuert werden.

Es ist auch der Fall denkbar, daß die beiden beschriebenen Ausführungsarten miteinander kombiniert werden, wobei sowohl ein aus Wasser oder Methanol bestehender Hilfsstoff H von die Reaktorkammer extern zugeführt wird als auch Reaktionsprodukte aus Wasser oder Methanol in die Reaktorkammer zurückgeführt werden.

Mit dem erfindungsgemäßen Verfahren kann ein ferroelektrischer Speicherkondensator und ein den Speicherkondensator enthaltender DRAM-Halbleiterspeicher hergestellt werden. In diesem Fall wird die Oberfläche des Substrats 3 bzw. 23 durch die untere Elektrodenschicht des Speicherkondensators gebildet.

Mit dem erfindungsgemäßen Verfahren kann ebenfalls ein ferroelektrischer Speichertransistor hergestellt werden, in welchem Fall die Oberfläche des Substrats 3 bzw. 23 durch den Kanalabschnitt eines MOS-Transistors gebildet wird.

## Patentansprüche

1. Verfahren zur Herstellung einer eine Perowskit-Struktur aufweisenden kristallinen, ferroelektrischen Strontium-Wismut-Tantalat-(SRT)-Festkörperschicht durch Gasphasenabscheidung auf einem Substrat (3; 23), bei welchem
- zusätzlich zu den die Elemente der abzuscheidenden Festkörperschicht enthaltenden Ausgangsgasen (P) ein Hilfsstoff (H) aus Wasser oder Methanol in einen Reaktionsraum eingeleitet wird, wobei
- der Reaktionsraum durch den Innenraum einer Reaktorkammer (10; 20) gebildet wird, in welcher eine Verteilerplatte (2; 22), insbesondere eine Lochplatte, angeordnet ist, auf deren einer Seite die Ausgangsgase (P), der Hilfsstoff (H) und gegebenenfalls ein Trägergas (T) durch Einlaßöffnungen in einer Reaktorwand (1; 21) eingeleitet werden und auf deren anderer Seite das Substrat (3; 23) gehaltert ist, und
- die Reaktorkammer (10; 20) ferner einen Gasauslaß (5; 25) aufweist, durch den die Reaktionsprodukte abgepumpt werden, und
- der Abstand zwischen der Verteilerplatte (2; 22) und dem Substrat (3; 23) auf weniger als 2 cm eingestellt wird.

2. Verfahren nach Anspruch 1,
**dadurch gekennzeichnet, daß**
- der Abstand zwischen der Verteilerplatte (2; 22) und dem Substrat (3; 23) auf etwa 1 cm eingestellt wird.

3. Verfahren nach Anspruch 1 oder 2,
**dadurch gekennzeichnet, daß**
- der Hilfsstoff (H) aus einer externen Versorgungsquelle wie einem Vorratsbehälter zugeführt wird.

4. Verfahren nach Anspruch 1 oder 2,
**dadurch gekennzeichnet, daß**
- der Hilfsstoff (H) aus den aus dem Reaktionsraum abgepumpte Reaktionsprodukte der Gasphasenabscheidung aufweist.

5. Verfahren nach Anspruch 4,
**dadurch gekennzeichnet, daß**
- die Reaktorkammer (20) eine weitere Gasauslaßöffnung (26) in der Reaktorwand (21) stromabwärts des Substrats (23) aufweist, wobei
- die Gasauslaßöffnung (26) mittels einer Verbindungsleitung (27) mit einer Einlaßöffnung stromaufwärts der Verteilerplatte (22) verbunden ist.

6. Verfahren nach Anspruch 5,
**dadurch gekennzeichnet, daß**
- in der Verbindungsleitung (27) ein Ventil (28) zur Steuerung des Gasflusses angeordnet ist.

## Claims

1. Method of producing a crystalline, ferroelectric strontium-bismuth-tantalate (SBT) solid-state layer by chemical vapor deposition on a substrate (3; 23), in which
- in addition to the starting gases (P) containing the elements of the solid-state layer to be deposited, an auxiliary substance (H) composed of water or methanol is introduced into a reaction space,
- the reaction space being formed by the interior space of a reactor chamber (10; 20), in which there is arranged a distributor plate (2; 22), in particular a perforated plate, on one side of which the starting gases (P), the auxiliary substance (H) and, if appropriate, a carrier gas (T) are introduced through inlet openings in a reactor wall (1; 21) and on the other side of which the substrate (3; 23) is mounted, and
- the reactor chamber (10; 20) also having a gas outlet (5; 25), through which the reaction products are pumped away, and
- the distance between the distributor plate (2; 22) and the substrate (3; 23) being set at less than 2 cm

2. Method according to Claim 1, **characterized in that**
- the distance between the distributor plate (2; 22) and the substrate (3; 23) is set at approximately 1 cm.

3. Method according to Claim 1 or 2, **characterized in that**
- the auxiliary substance (H) is fed in from an external supply source, such as a storage container.

4. Method according to Claim 1 or 2, **characterized in that**
- the auxiliary substance (H) comprises the reaction products of the chemical vapor deposition pumped away from the reaction space.

5. Method according to claim 4, **characterized in that**
- the reactor chamber (20) has a further gas outlet opening (26) in the reactor wall (21) downstream of the substrate (23),
- the gas outlet opening (26) being connected by means of a connecting line (27) to an inlet opening upstream of the distributor plate (22).

6. The method according to claim 5, **characterized in that**
- a valve (28) for controlling the gas flow is arranged in the connecting line (27).

## Revendications

1. Procédé de production d'une couche de semi-conducteur cristalline, ferroélectrique, en tantale de strontium et de bismuth (SRT) et ayant une structure perovskite par dépôt en phase gazeuse sur un substrat (3 ; 23), dans lequel
- en plus des gaz (P) de départ contenant les éléments de la couche de semi-conducteur à déposer, on introduit dans un espace de réaction une substance (H) auxiliaire constituée d'eau ou de méthanol, dans lequel
- on forme l'espace de réaction par l'intérieur d'une chambre (10 ; 20) de réacteur, dans laquelle est disposée une plaque (2 ; 22) formant répartiteur, notamment une plaque perforée, sur une face de laquelle on introduit les gaz (P) de départ, la substance (H) auxiliaire et, le cas échéant, un gaz (T) porteur par des ouvertures d'entrée dans une paroi (1 ; 21) du réacteur et sur l'autre face de laquelle on maintient le substrat (3 ; 23) et
- la chambre (10 ; 20) de réacteur a, en outre, une sortie (5 ; 25) pour les gaz par laquelle on évacue les produits de réaction par pompage, et
- on règle la distance entre la plaque (2 ; 22) formant répartiteur et le substrat (23) à moins de 2 cm.

2. Procédé suivant la revendication 1,
**caractérisé en ce que**
- on règle la distance entre la plaque (2 ; 22) formant répartiteur et le substrat (3 ; 23) à environ 1 cm.

3. Procédé suivant la revendication 1 ou 2,
**caractérisé en ce que**
- on apporte la substance (H) auxiliaire à partir d'une source extérieure d'alimentation, comme un réservoir.

4. Procédé suivant la revendication 1 ou 2,
**caractérisé en ce que**
- on envoie au dépôt en phase gazeuse la substance (H) auxiliaire constituée des produits de réaction évacués par pompage de l'espace de réaction.

5. Procédé suivant la revendication 4,
**caractérisé en ce que**
- la chambre (20) de réacteur a une autre ouverture (26) d'entrée des gaz dans la paroi (21) du réacteur en aval du substrat (23), dans lequel
- l'ouverture (26) de sortie des gaz communique au moyen d'un conduit (27) de communication avec une ouverture d'entrée en aval de la plaque (22) formant répartiteur.

6. Procédé suivant la revendication 5,
**caractérisé en ce que**
- une vanne (28) de commande du débit gazeux est montée dans le conduit (27) de communication.
